# FASCICULE DE BREVET EUROPEEN

(11) **EP 3 655 821 B1**
(45) Date de publication et mention de la délivrance du brevet: **14.07.2021**
(21) Numéro de dépôt: 18737918.5
(22) Date de dépôt: 11.07.2018
(51) Int. Cl.: G03F 9/00

(54) **PROCÉDÉ ET SYSTÈME DE LITHOGRAPHIE INTERFÉRENTIELLE**
INTERFERENZLITHOGRAPHIE -VERFAHREN UND -SYSTEM
INTERFERENCE LITHOGRAPHY PROCESS AND SYSTEM

(30) Priorité: 19.07.2017 FR 1756863
(43) Date de publication de la demande: 27.05.2020
(73) Titulaire: Université de Technologie de Troyes, 10000 Troyes (FR)
(72) Inventeur: LERONDEL, Gilles, 10800 Saint Julien les Villas (FR); TOURY, Timothée, 10190 Prugny (FR); IBRAHIM, Joyce, 67500 Haguenau (FR); RUMYANTSEVA, Anna, 10000 Troyes (FR)
(74) Mandataire: Office Freylinger
(86) Numéro de dépôt international: PCT/EP2018/068793
(87) Numéro de publication internationale: WO 2019/016045

(56) Documents cités:
- US-A- 5 759 744
- S.R.J. BRUECK: "Optical and Interferometric Lithography - Nanotechnology Enablers", PROCEEDINGS OF THE IEEE., vol. 93, no. 10, 1 octobre 2005 (2005-10-01), pages 1704-1721, XP055459398, US ISSN: 0018-9219, DOI: 10.1109/JPROC.2005.853538
- BOOR DE J ET AL: "Three-beam interference lithography: upgrading a Lloyd's interferometer for single-exposure hexagonal patterning", OPTICS LETTERS, OPTICAL SOCIETY OF AMERICA, vol. 34, no. 12, 15 juin 2009 (2009-06-15) , pages 1783-1785, XP001523584, ISSN: 0146-9592, DOI: 10.1364/OL.34.001783
- WU LIJUN ET AL: "Fabrication of large area two- and three-dimensional polymer photonic crystals using single refracting prism holographic lithography", APPLIED PHYSICS LETTERS, A I P PUBLISHING LLC, US, vol. 86, no. 24, 7 juin 2005 (2005-06-07), pages 241102-241102, XP012065838, ISSN: 0003-6951, DOI: 10.1063/1.1947369
- Ngoc D Lai ET AL: "Fabrication of two- and three-dimensional quasi-periodic structures with 12-fold symmetry by interference technique", Optics express, 30 octobre 2006 (2006-10-30), pages 10746-1953, XP055460153, United States DOI: 10.1364/OE.14.010746 Extrait de l'Internet: URL:https://www.osapublishing.org/DirectPD FAccess/CF306A0D-9284-58D7-294A6BEA3104466 2_116595/oe-14-22-10746.pdf?da=1&id=116595 &seq=0&mobile=no [extrait le 2018-03-15]

## Description

L'invention concerne généralement le domaine de la structuration de substrats par lithographie interférentielle, dite aussi lithographie holographique. De manière plus particulière, l'invention vise l'utilisation de la lithographie interférentielle pour la fabrication de méso- ou nanostructures métalliques sur des substrats, notamment en vue de la réalisation de capteurs pour la plasmonique.

### ÉTAT DE LA TECHNIQUE ANTÉRIEURE

Comme on le sait, le domaine de la plasmonique est basé sur l'interaction entre un faisceau lumineux et les électrons matériau à électrons libres (métal ou semi-conducteur fortement dopé), souvent sous forme de nanoparticules, nanostructures ou surfaces nanostructurées. Ces structures métalliques sont principalement utilisées dans le domaine des capteurs et détection des polluants mais également des capteurs de marqueurs biologiques de pathologies (protéines, etc.). Parmi les techniques les plus prometteuses, est la technique dite SERS pour Surface Enhanced Raman Spectroscopy qui permet de détecter les molécules présentes dans une solution qui se déposent sur une surface en exaltant leur réponse Raman ou encore le SEIRA pour Surface Enhanced InfraRed Absorption.

D'une manière générale, plusieurs techniques ont été utilisées pour la fabrication de nanoparticules métalliques (voir notamment G. Lérondel et al. dans Nanofabrication for plasmonics, Plasmonics, Springer Series in Optical Sciences 167, 2012*),* certaines d'entre elles étant brièvement mentionnées ci-après.

**La lithographie optique.** Cette technique typiquement employée en microélectronique consiste à illuminer une résine photosensible avec une source optique monochromatique à travers un masque qui a la forme des structures/particules souhaitées (résine positive), ou une forme complémentaire (résine négative). Elle est limitée en résolution à la fois par les propriétés de la résine, et par la longueur d'onde du faisceau utilisé. Les longueurs d'ondes utilisées aujourd'hui se situent dans l'UV profond (190 nm) ou EUV (12 nm) seraient compatibles avec les dimensions typiques de structures plasmoniques (50 nm), cependant le coût des instruments et des procédés est prohibitif pour la réalisation de grandes surfaces nanostructurées jetables (ou consommables) pour des capteurs plasmoniques et nécessite bien entendu la fabrication de masques spécifiques.

**La lithographie par nano-sphères.** Ce procédé a été le premier utilisé pour réaliser des structures plasmoniques à forme contrôlée. Il consiste à auto-organiser des nano-sphères sur l'échantillon, suivi par une évaporation du métal souhaité et retrait des nano-sphères. On obtient des nanoparticules métalliques dans les interstices du réseau de nano-sphères et par conséquent les formes de structures obtenues sont limitées à des triangles typiquement. Cette technique est simple, compatible à grande échelle mais limitée par l'absence d'ordre à grande distance aux échelles microniques (10 à 20 fois typiquement la taille des billes).

**La lithographie électronique.** La résine (typiquement du PMMA) est exposée localement à l'aide d'un faisceau d'électrons. La résolution est de quelques nm. Combinée au procédé lift-off, cette technique permet un dépôt localisé de métal (après une étape de révélation de la résine). Comme pour la technique voisine d'écriture par faisceau d'ions focalisés, la vitesse d'écriture est lente. Cette technique est utilisée en SERS car elle permet un contrôle complet sur la forme et l'espacement entre les particules. Elle n'est cependant pas compatible à grande échelle avec des temps typiques d'exposition pour les plus rapides de 2h pour 1 mm².

**Lithographie interférentielle.** La lithographie interférentielle consiste à créer une figure d'interférences à la surface d'un matériau photosensible. Cette technique est compatible avec une grande surface à structurer et permet la réalisation de motifs de forme et géométrie variées. Cette technique est limitée à la réalisation de structure périodique ou quasi-périodique avec un espacement minimal égal à la moitié de la longueur d'onde du laser. La taille des structures n'est par contre pas limitée et peut être ajustée en fonction de la dose et des propriétés de la résine. Il est possible cependant de diminuer l'espacement des structures en travaillant en immersion i.e. en changeant l'indice de réfraction du milieu. Notons encore que la lithographie interférentielle par l'utilisation de figure d'interférence permet d'obtenir potentiellement les structures les plus régulières réalisables sur de grandes surfaces. La limitation principale vient de la qualité des faisceaux laser étendus.

On citera à titre d'exemple les documents suivants qui décrivent la lithographie interférentielle à deux et trois faisceaux : US 5,759,744 ; S.R.J. Brueck : 'Optical and interferometric lithpography - Nanotechnology enablers', PROCEEDINGS OF THE IEEE, vol. 93 no. 10 (2005-10-01), pages 1704-1721) ; Boor J. et al. : 'Three beam interference lithography : upgrading a Lloyd's interferometer for single-exposure hexagonal patterning', OPTICS LETTERS, OPTICAL SOCIETY OF AMERICA, vol.34, no.12, 2009-06-15, pages 1783-1785; et Ngoc D lai et Al. : 'Fabrication of two- and three-dimensional quasi-periodic structures with 12-fold symmetry by interference technique', Optics express, 2006-10-30, pages 10746-1953.

Appliquée à la structuration de matériaux inorganiques, la technique de lithographie interférentielle est avant tout une technique de masquage et doit être combinée avec des techniques de transfert comme la gravure ou le procédé lift-off, comme pour les deux techniques précédentes.

Concernant plus spécifiquement les structures plasmoniques dans le domaine SERS, le FR 2 964 469 décrit la réalisation de motifs à symétrie limitée particulièrement intéressants. Notamment, on y décrit un capteur comportant un substrat présentant une face comportant des nanoparticules ayant une forme d'étoile à trois branches. Ces étoiles sont réalisées dans un matériau métallique et/ou semi-conducteur et ont des dimensions de l'ordre du nanomètre à quelques dizaines de micromètres.

Cette structure en étoile proposée dans le FR 2 964 469 est très avantageuse, car il a été observé que l'intensité de la résonance plasmon pour une particule ayant une forme d'étoile à trois branches, varie très faiblement quel que soit l'angle de polarisation. Cette faible variation d'intensité induit une indépendance suffisante et intéressante de l'ensemble des propriétés de la particule vis-à-vis de la polarisation. En fait, plusieurs avantages sont liés à l'utilisation de particules ayant un ordre de symétrie supérieur ou égal à trois : d'abord une grande variété de formes réponde à cette définition ; d'où une très grande souplesse à la fois dans l'architecture et dans la géométrie des particules utilisées. Ceci permet d'obtenir des facteurs d'exaltation de champ bien supérieurs à ceux obtenus avec des particules cylindriques ou sphériques, dont le rayon de courbure est trop grand pour permettre une exaltation efficace.

La méthode de fabrication décrite dans le FR 2 964 469 est la lithographie électronique. Comme discuté ci-dessus, cette technique permet un contrôle précis de la géométrie des structures et une bonne reproductibilité. La lithographie électronique, ou la lithographie ionique focalisée, ont pour cela été largement employées pour la réalisation de réseaux de nano-trous. Mais la lithographie électronique et la lithographie ionique focalisée sont inappropriées en raison de leur lenteur pour la structuration de surfaces larges, dans le contexte d'une production de masse.

Il serait donc souhaitable de disposer d'une méthode de structuration rapide adaptée au domaine de la plasmonique, plus particulièrement pour la fabrication de structures à symétrie limitée, tel que des étoiles à trois branches.

### EXPOSÉ DE L'INVENTION

La présente invention concerne un procédé de fabrication de structures à symétrie limitée par lithographie interférentielle comprenant une étape d'insolation par lithographie interférentielle d'un matériau photosensible disposé sur un substrat.

Selon l'invention, l'étape d'insolation comprend au moins trois expositions interférentielles successives réalisées avec trois faisceaux lumineux coplanaires, émis par un système optique de sorte à interférer ensemble sur une même partie du matériau photosensible, dite surface d'exposition. Une rotation relative est réalisée entre le système optique et le substrat entre la première et la deuxième exposition interférentielle, puis entre la deuxième et la troisième exposition interférentielle.

Un mérite des présents inventeurs est d'avoir mis au point, de manière surprenante et non-prévisible, une étape d'insolation par lithographie interférentielle permettant de réaliser des structures géométriques complexes à symétrie limitée, notamment des étoiles à trois branches.

Jusqu'à présent, comme indiqué dans la partie relative à l'état de la technique, la lithographie interférentielle avait été utilisée pour la fabrication de structures simples, notamment des particules ou trous cylindriques. Des structures du type étoile d'or à trois branches, très utiles pour la plasmonique, avaient été fabriquées par lithographie électronique, comme décrit dans le FR 2 964 469.

La présente invention va donc permettre la fabrication de masse de substrats avec des méso ou nanostructures à symétrie limitée, en profitant des avantages de la lithographie interférentielle : facilité de mise en œuvre, vitesse de production rapide, traitement de larges surfaces...

Dans la présente, le terme « symétrie limitée » est utilisé pour se distinguer d'objets tels que des plots. En particulier, on entend par « méso ou nanostructures à symétrie limitée » des structures comprenant des méso ou nano-particules, connexes ou non, présentant une symétrie d'ordre n, où n≥3. C'est-à-dire que la particule est invariante par rotation autour d'un axe perpendiculaire à la surface du substrat d'un angle 2Pi/n, où n est supérieur ou égal à trois. Avec la terminologie des « groupes de papier peint », c'est-à-dire des groupes mathématiques constitués par l'ensemble des symétries d'un motif bidimensionnel périodique, le terme « symétrie limitée » représente les groupes p6, p6m, p3, p31m et p3m1. Ces motifs ne sont pas nécessairement des particules indépendantes, mais sont une structuration nanométrique ou micrométrique des motifs périodiques. Rappelons que nous entendons ici par nanométrique des objets de taille inférieur à 100nm, par mesoscopique des objets de taille comprise entre 100 nm et 1 micron et micronique des objets de taille supérieure au micron.

Le présent procédé est bien entendu compatible avec les technologies conventionnelles de lithographie. En pratique, le procédé comprendra généralement : une étape de préparation du substrat, dans laquelle il est recouvert d'un film de résine photosensible ; l'étape d'insolation conforme à l'invention ; une étape de développement de la résine, afin de libérer sélectivement les zones insolées ou non-insolées (selon que la résine est positive ou négative) par la figure d'interférence ; et une étape dite de transfert, dans laquelle on réalise un dépôt métallique sur la résine/substrat, par exemple suivi soit d'une gravure ou d'un lift-off.

A noter que les techniques de transfert type gravure ou lift off sont surtout requises pour la structuration de surface des substrats/matériaux inorganiques.

De manière générale, on pourra jouer sur différents paramètres opératoires pour faire varier les formes géométriques des méso ou nanostructures fabriquées, parmi lesquels notamment : intensité totale des faisceaux, intensités relatives des faisceaux, phases relatives des faisceaux, angles d'incidence des faisceaux, angles de rotation de l'échantillon, durée d'exposition.

De préférence, on contrôle les intensités relatives des faisceaux. Par exemple, les faisceaux extérieurs ont la même intensité et l'intensité du faisceau central est réduite, par ex. de 50%.

Pour un bon contrôle de la géométrie des structures sur la surface exposée, on contrôle avantageusement la phase de chacun des faisceaux, par exemple au moyen d'un dispositif de contrôle de phase. Tout type de dispositif de contrôle de phase approprié peut être utilisé, on citera à titre d'exemple un miroir posé sur un cristal piézoélectrique. La modulation de phase est notamment effectuée pour former des motifs d'étoiles ou de points dans la résine photosensible. Sans contrôle la de phase, la technique reste également intéressante car elle aboutit à des zones de structures différentes qui potentiellement résonnent à des longueurs d'onde différente. Dans le cadre de capteurs plasmoniques, cela permet donc d'envisager une détection combinée de plusieurs espèces.

Comme on le comprendra, lors d'une exposition interférentielle, la résine reçoit une certaine dose d'insolation, fonction de la combinaison des différents paramètres mentionnés ci-dessus. Selon les variantes, les doses d'insolation peuvent être identiques ou différentes entre chaque exposition interférentielle. Le nombre expositions interférentielles peut également être supérieur à trois, par exemple avec un pas angulaire de 180°/n (n étant le nombre d'expositions). Des expositions avec des pas différents sont possibles, par exemple, 30° puis 60° et enfin 120°.

Selon un mode de réalisation, les faisceaux lumineux coplanaires sont émis par un système optique qui produit : un faisceau central, de préférence ayant un angle d'incidence normal par rapport au plan du substrat, et deux faisceaux latéraux (de phase relative avec le faisceau central fixée), de part et d'autre du faisceau central, tous les trois dans un même plan, les faisceaux latéraux ayant un angle d'incidence inférieur à 90° par rapport au plan moyen du substrat (respectivement de la couche de matériau photosensible), les trois faisceaux lumineux étant dirigés sensiblement sur la surface d'exposition du matériau photosensible afin de produire une figure d'interférences.

L'angle d'incidence des faisceaux latéraux techniquement peut être compris entre 5° et 70° (angle par rapport à la normale à la surface).

Selon les variantes, on pourra faire varier l'angle de rotation du substrat en fonction de la taille des structures désirées. La rotation est typiquement réalisée dans le plan du substrat. Préférablement, pour des géométries en étoile on pivote le substrat de 60° entre chaque exposition interférentielle (en partant d'une position initiale 0°) ; l'étape d'insolation comprend donc trois expositions dans des positions à 0°, 60° et 120°. En pratique, la rotation relative du substrat est préférablement réalisée par déplacement-rotation du substrat.

Comme on le comprendra, pour des angles différents, on pourra avoir un nombre d'expositions différents. Par exemple, pour un angle de 45° on réalise quatre expositions à 45, 90 et 135°. En outre, les paramètres de chaque exposition peuvent aussi différer.

Le substrat sera choisi en fonction des applications, il peut s'agir de silicium, de verre (tranparent dans l'infrarouge et/ou le visible et/ou l'ultraviolet), de chalcogénures, ou de systèmes structurés tels que des guides d'ondes sur lesquels on vient structurer des nanoparticules. Les méso ou nanoparticules à symétrie limitées sont fabriquées dans des matériaux adaptés au processus de transfert choisi, il peut s'agir de métaux (or, argent, aluminium, chrome, cuivre notamment) en dépôt simple ou des couches de métaux différents (or sur couche d'accroché de chrome, par exemple) ou semi-conducteurs intrinsèques ou dopés (incluant ceux à haut gap tel que le ZnO), ou encore d'oxydes via des procédés solgel.

De manière plus particulière, le présent procédé permet la fabrication de structures comprenant des méso ou nano-particules présentant une symétrie d'ordre Cn, où n≥3 (comme noté en théorie des groupes). C'est-à-dire que la particule est invariante par rotation autour d'un axe perpendiculaire à la surface du substrat d'un angle 2Pi/n, où n est supérieur ou égal à trois.

En considération des applications à la plasmonique, le présent procédé permet la fabrication de structures constituées de nanoparticules ou groupes de nanoparticules présentant une forme (pour les nanoparticules) ou une disposition (pour les groupes de particules) ayant un axe de symétrie perpendiculaire à ladite face de type Cn où n est supérieur ou égal à trois, de façon à permettre une forte exaltation dudit faisceau à proximité de ladite face, lors de la mise en œuvre du capteur fabriqué avec ce type de structure. La forme étant adaptée aux résonances plasmoniques aux fréquences désirées.

Les structures à symétrie limitée de type étoiles sont ici particulièrement intéressantes, car un effet d'amplification de champ est attendu quelle que soit la polarisation incidentes. Ce type de structures trouve des applications dans le domaine de la détection amplifiée de type Raman (SERS) ou absorption infrarouge type SEIRA.

Toujours dans le cadre de la plasmonique, le présent procédé est préférablement utilisé pour la fabrication de structures comprenant des nanoparticules présentant dans leur majorité une forme en étoile ayant au moins trois branches. Les nanoparticules peuvent être métalliques et/ou semi conductrices. Elles présentent préférentiellement une dimension comprise entre le nanomètre et quelques dizaines de micromètres. En outre en fonction du réseau dans lequel lesdites nanoparticules sont incluses, on peut avoir un pavage régulier ou quasi-cristallin. Le substrat peut être constitué d'un matériau transparent aux longueurs d'onde des ultraviolets, du visible et/ou de l'infrarouge. La dimension desdites nanoparticules ou groupes de nanoparticules pourra être choisie de façon à ce qu'elles soient accordées sur une longueur d'onde du faisceau incident utilisé pour la lecture du capteur. En général, les nanoparticules sont disposées sur au moins une partie du substrat, selon un pavage régulier ou quasi cristallin ou aléatoire.

Les substrats fabriqués selon le présent procédé peuvent être employés pour la détection et/ou la mesure de molécules et/ou de cibles de type chimique, biochimique ou biologique. De tels substrats seront avantageusement employés pour la détection et/ou la mesure de molécules et/ou de supra-molécules et/ou de particules dans un milieu liquide (souvent aqueux) et/ou biologique et/ou encore dans des fluides corporels tels que le sang. Selon ce dernier type d'application, des virus ou bactéries pourront être identifiés, y compris au niveau individuel.

Selon un autre aspect, l'invention concerne aussi un système optique particulièrement adapté pour la fabrication de structures à symétrie limitée par lithographie interférentielle, comprenant :
un porte échantillon ;
une source de lumière cohérente émettant un faisceau lumineux source ;
des moyens pour former, à partir du faisceau source, trois faisceaux lumineux coplanaires dirigés sur une surface d'exposition d'une résine photosensible recouvrant un substrat de sorte à interférer ; et
des moyens pour faire pivoter le porte échantillon afin de réaliser plusieurs expositions interférentielles de la résine.

Le système est remarquable en ce que les moyens pour former le faisceau comprennent un prisme comprenant une face inférieure et une face supérieure planes et parallèles et deux faces latérales opposés obliques, la face inférieure du prisme étant positionnée à proximité ou en contact d'un substrat recouvert d'une couche de résine photosensible lors de l'utilisation, alors que le faisceau lumineux source est dirigé perpendiculaire à la face inférieure du prisme, et tombe sur la face supérieure du prisme ainsi que sur deux face latérales obliques.

Le prisme est configuré de sorte que les faisceaux pénétrant par la face supérieure arrivent avec une incidence normale sur la face inférieure et les faisceaux lumineux pénétrant par lesdites faces latérales obliques convergent vers la face inférieure du prisme pour interférer.

Ce système optique est particulièrement bien adapté pour la mise en œuvre du procédé décrit ci-avant. Le prisme tronqué confère au système une grande compacité, réduisant le nombre de pièces à un minimum. En outre, le prisme tronqué agit comme séparateur, formant trois faisceaux coplanaires distincts, tout en dirigeant ces faisceaux de manière à les faire converger à la base du prisme pour interférer. Enfin, dans un environnement aux conditions simples à contrôler (notamment stabilité raisonnable de la température et des supports mécaniques), les phases relatives des trois faisceaux restent suffisamment fixées (contrôlées) pour assurer la figure d'interférences voulues.

De préférence, une couche d'adaptation d'épaisseur est déposée sur chacune ou une des desdites faces latérales opposées du prisme pour contrôler la phase relative des faisceaux lumineux.

Une densité optique est positionnée sur le chemin des faisceaux lumineux tombant sur les faces latérales, ou sur le chemin des faisceaux lumineux tombant sur la face tronquée du prisme, afin d'atténuer leur intensité, ladite densité optique pouvant prendre la forme d'une lame positionnée à distance du prisme ou bien d'une couche formée sur le prisme, respectivement sur ladite couche d'adaptation d'épaisseur.

### BRÈVE DESCRIPTION DES FIGURES

D'autres particularités et caractéristiques de l'invention ressortiront de la description détaillée d'au moins un mode de réalisation avantageux présenté ci-dessous, à titre d'illustration, en se référant aux dessins annexés. Ceux-ci montrent :
Figure 1 : un schéma de principe représentant une exposition à 3 faisceaux coplanaires ;
Figure 2 : une image MEB de structures d'étoiles à trois branches en or (après lift off) obtenues sur un substrat silicium au moyen du présent procédé ;
Figure 3 : est un schéma de principe d'un système optique utilisé pour la mise en œuvre du présent procédé ;
Figure 4 : est un schéma illustrant par étapes un mode de réalisation du présent procédé de lithographie avec transfert par le process de lift-off ;
Figure 5 : est un tableau représentant diverses formes (simulation) de méso- ou nanostructures pouvant être obtenues par le présent procédé ; et
Figure 6 : est un schéma de schéma de principe d'un autre système optique utilisé pour la mise en œuvre du présent procédé.

### DESCRIPTION DÉTAILLÉE D'AU MOINS UN MODE DE RÉALISATION

La présente invention porte sur l'utilisation de la lithographie interférentielle à trois faisceaux coplanaires avec expositions multiples pour la réalisation de structures à symétrie limitée, comme par exemple la réalisation d'étoiles à 3 branches obtenues par triple exposition.

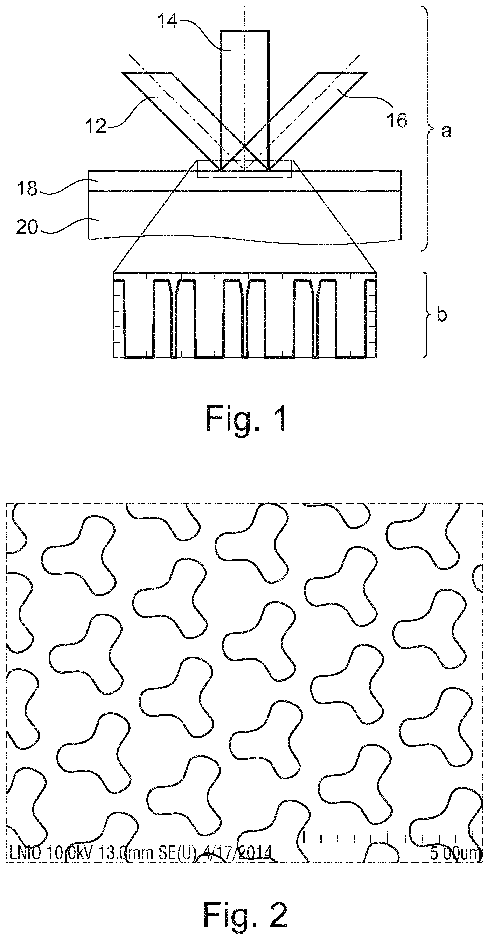

Sur la Fig. 1a) on a représenté schématiquement une exposition à trois faisceaux coplanaires 12, 14, 16. Les trois faisceaux sont des faisceaux de lumière distincts et cohérents, dirigés sur une même région d'une résine photosensible 18 disposée sur un substrat 20, sous des angles d'incidence différents. Les trois faisceaux vont interférer pour former une figure d'interférences. La figure d'interférences réalise une sorte de masquage de la résine 18, car elle comprend des zones d'intensité lumineuses variables, résultant en des zones insolées ou non-insolées de la résine. Ainsi, la figure d'interférences permet une insolation spatialement sélective de la résine 18, induisant un motif correspondant dans celle-ci.

La Fig. 1b) montre le profil d'insolation obtenu dans la résine 18 après une seule exposition interférentielle à trois faisceaux coplanaires dont les intensités relatives sont différentes (ici l'intensité du faisceau central représente la moitié de celle des faisceaux latéraux). Pour une simple exposition, on obtient un ensemble de lignes parallèles, avec deux espacements différents. Dans la présente, on parle d'« exposition interférentielle » pour marquer le fait que durant l'exposition les trois faisceaux coplanaires interfèrent, par distinction avec d'autres méthodes lithographiques dans lesquelles l'étape d'exposition ne fait pas appel à un masquage par figures d'interférences.

Mais on appréciera qu'en effectuant plusieurs expositions interférentielles, avec rotation du substrat, ces lignes disparaissent et l'on obtient des motifs de symétrie limitée.

De manière surprenante et non-prévisible, les présents inventeurs ont en effet découvert qu'une triple exposition avec trois faisceaux coplanaires, tel qu'illustré à la figure 1a), permet d'obtenir des structures symétriques de particules à géométrie complexe, et notamment des structures d'étoiles à trois branches. Un exemple d'étoiles à trois branches obtenu au moyen du présent procédé est montré sur l'image de microscope électronique à balayage (MEB) de la Fig.2.

De manière générale, on pourra obtenir différents motifs à symétrie limitée en modifiant les paramètres d'exposition, parmi lesquels : décalages de phases relatives entre faisceaux, intensités relatives entre faisceaux, angles d'incidence des faisceaux, durée d'exposition, angle de rotation.

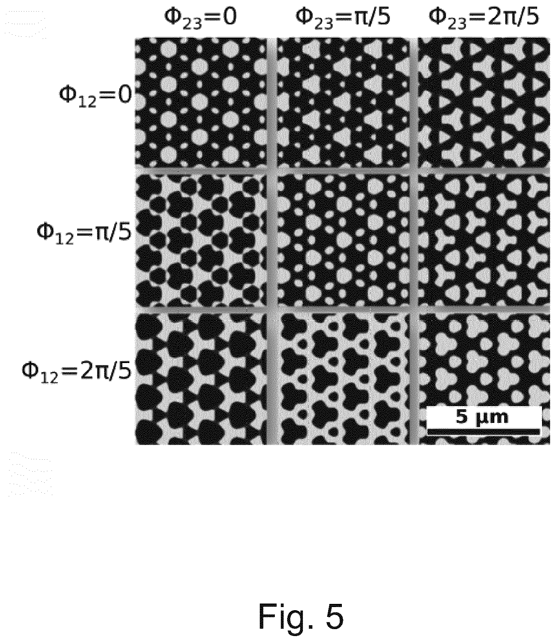

A titre d'exemple, la figure 5 montre une simulation des différents motifs à symétrie limitée que l'on peut obtenir en variant les phases relatives entre les faisceaux 12 et 14 (différence de phase notée Φ₁₂) et les faisceaux 14 et 16 noté (différence de phase notée Φ₂₃).

Pour la réalisation de méso- ou nanostructures métalliques à symétrie limitée, le principe d'une exposition interférentielle multiple à trois faisceaux coplanaires est combiné avec les étapes conventionnelles des procédés lithographiques. Le processus de réalisation complet comprendra donc typiquement étapes de :
1. Préparation du substrat: dépôt du matériau sacrificiel, i.e. une résine photosensible, sur la surface du substrat ;
2. Insolation du substrat (que l'on peut également appeler étape de masquage) : multiple exposition interférentielle du substrat à trois faisceaux coplanaires, avec rotation du substrat, pour exposer sélectivement des zones de résines conformément à la figures d'interférences créée sur la résine ;
3. Développement de la résine pour libérer sélectivement des parties définies par l'étape d'insolation ;
4. Fabrication de la structure : on dépose le métal selon les motifs formés dans la résine, par un procédé approprié, dont par exemple lift-off ou gravure.

Les étapes 1, 3 et 4 sont classiques et ne seront donc pas expliquées en détail (sauf dans le cadre d'un exemple ci-dessous). Elles peuvent être mises en œuvre avec les matériaux et appareils existants.

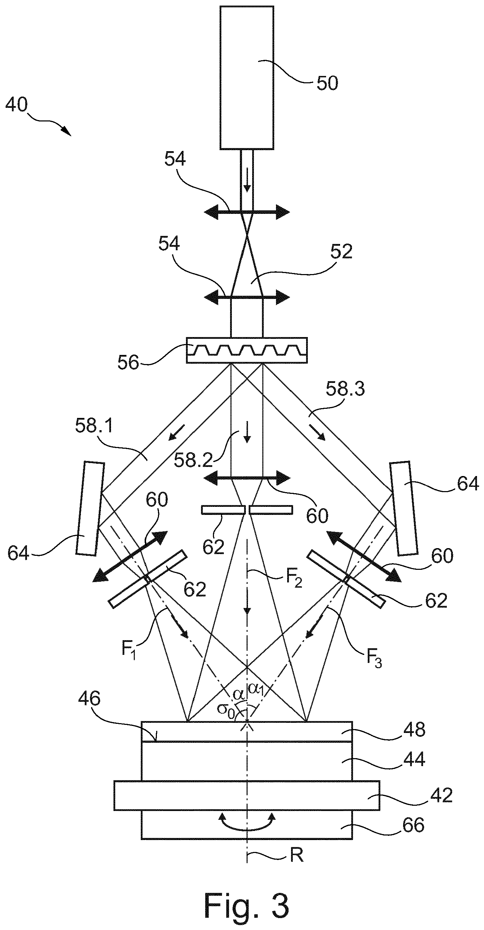

On va maintenant décrire un système optique 40 permettant de réaliser une étape d'insolation conforme à l'invention, lequel est représenté schématiquement en Figure 3.

Sur un porte échantillon 42 on a placé un substrat 44 dont la surface supérieure 46 est couverte d'un film de résine photosensible 48. Le substrat 44 est par exemple en silicium, mais peut être en tout matériau approprié. La résine photosensible 48 peut également être de tout type approprié, qui sera notamment choisi en fonction de la longueur d'onde des faisceaux incidents et de la résolution souhaitée. En vue d'un transfert avec le procédé lift-off, on utilisera avantageusement une résine positive avec seuil (par exemple de type S1813). Classiquement, le type de résine est adapté à la longueur d'onde qui est utilisée pour son insolation.

Le signe de référence 50 désigne une source laser ayant une longueur d'onde prédéterminée. Le faisceau de lumière cohérente 52 produit par la source est d'abord étendu à travers une paire de lentilles 54, avant de rencontrer un masque de phase 56. L'idée est d'élargir le faisceau source 52 afin qu'il s'étende sur une grande surface du masque, par exemple pour atteindre un diamètre de l'ordre de 1 cm.

Le masque de phase 56 sert à diviser le faisceau source 52 en trois faisceaux de vecteurs d'onde coplanaires 58.1, 58.2 et 58.3. Le faisceau 58.2 est dit « central » et les faisceaux 58.1 et 58.2 sont dits « latéraux » ou « extérieurs ». Le masque de phase 56 peut être un réseau de diffraction classique et on pourra employer un masque de phase du commerce. A titre d'exemple, on peut citer un masque de phase de la société IBSEN, ayant une taille de 1 cm x 1 cm et une période 490 nm conçu pour la lumière polarisée S. Avec un tel masque, l'intensité du faisceau central est égale à la moitié des deux autres. Chaque faisceau 58.1, 58.2 et 58.3 est avantageusement filtré spatialement en passant d'abord au travers d'une lentille 60 puis un orifice 62 (pinhole), ce qui permet une distribution homogène d'intensité. Par exemple, on peut employer une lentille de focale de 7.5 cm et un orifice de 5 µm.

On notera que le masque de phase peut être substitué par tout dispositif apte à séparer la source de lumière cohérente en trois faisceaux de vecteurs d'onde coplanaires. On pourra par exemple employer alternativement un réseau de diffraction.

Le faisceau central 58.2 sort du masque de phase 56 perpendiculairement à celui-ci, et a donc une incidence normale sur la face supérieure de la résine 48. Deux miroirs 64 sont utilisés pour faire converger les faisceaux 58.1 et 58.3 latéraux vers la zone d'incidence du faisceau central, de sorte que les trois faisceaux interfèrent sur une même partie de la résine dite « surface d'exposition ». Les angles d'incidence respectifs des trois faisceaux 58.1, 58.2 et 58.3 sont notés θ₁, θ₀ et θ₂. L'angle α₀ entre le faisceau central F2 et la surface supérieure de la résine vaut 90°. Les angles θ₁ et θ₂ (angle par rapport au faisceau central F2) sont généralement entre 5 et 70°, en particulier de l'ordre de 20°.

La rencontre des trois faisceaux 58.1, 58.2 et 58.3 au niveau de la surface d'exposition va donc générer une figure d'interférences, qui va permettre d'induire un motif dans le film de résine 48. Comme on le comprendra, la figure d'interférence comprend des zones d'intensités lumineuses variées, qui vont, selon le seuil de sensibilité de la résine, engendrer des zones insolées de la résine ou des zones non-insolées, conformément au motif d'interférences.

L'intérêt de la lithographie interférentielle est ici la capacité de traiter des surfaces relativement grandes par une seule étape d'insolation, allant avec les moyens techniques actuels jusqu'à environ 1 cm², de plus grandes surfaces étant possibles avec une optique adaptée et des lasers plus puissants.

Les conditions exposées ci-avant sont utilisées pour réaliser trois expositions, notamment en vue d'obtenir les motifs d'étoiles à trois branches. Selon les variantes davantage d'expositions peuvent être réalisées, et d'autres formes géométriques symétriques obtenues.

Dans le cadre de la triple exposition interférentielle, une première exposition est réalisée, référencée en tant que position 0°. Puis l'on opère une première rotation de l'échantillon de 60° dans son plan, pour réaliser une deuxième exposition - position 60°. Enfin on tourne encore l'échantillon de 60° dans le même sens (donc de 120° par rapport à la position 0°), pour réaliser une troisième exposition en position 120°. Pour cet exemple, les conditions d'exposition sont les mêmes pour les trois expositions.

La rotation de l'échantillon est préférée car elle est plus simple à réaliser que la rotation du système optique. Le porte échantillon est par exemple monté sur un socle pivotant 66 comprenant un moteur électrique piloté. On notera que le pivotement du substrat se fait de préférence selon un axe de rotation R confondu avec l'axe F₂ du faisceau central 58.2.

En pratique, on pourra jouer sur différents paramètres opératoires pour faire varier les formes géométriques des nanostructures fabriquées, parmi lesquels notamment : intensités des faisceaux, phases des faisceaux, angle d'incidence des faisceaux, angles de rotation de l'échantillon, durée d'exposition.

Concernant l'intensité des faisceaux, on pourra moduler les intensités relatives. De préférence, les faisceaux extérieurs ont la même intensité et l'intensité du faisceau central est réduite, par ex. de 50%.

Concernant les phases des faisceaux, celles-ci peuvent être laissée libres. Il est toutefois préférable de contrôler les phases respectives des faisceaux, par ex. au moyen d'un contrôleur de phase sur chaque faisceau, pour mieux maitriser la géométrie du motif fabriqué sur la totalité de la surface exposée. Par ailleurs, la modulation de phase entre les différents faisceaux permet de faire varier les motifs, comme vu par exemple en Fig.5.

### Exemple de fabrication de nano-étoiles d'or à trois branches

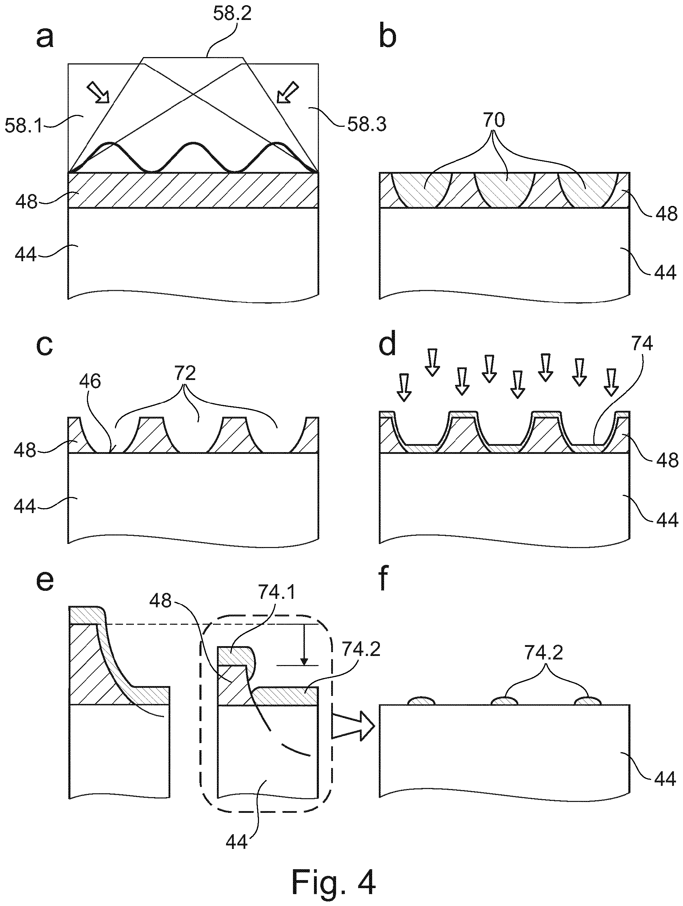

On va maintenant décrire, à l'aide de la Figure 4, les étapes principales du présent procédé de fabrication de nano-structures, dans une variante appliquée à la fabrication de nano-étoiles du type illustré à la Fig.2, et utilisant l'évaporation d'or et le processus de lift-off.

### 1. Préparation du substrat et insolation de la résine - Fig.4 a) et b)

En se référant à la Fig.4, on reconnait à l'image a) un substrat silicium 44 revêtu sur sa face supérieure d'une résine photosensible 48 (pour des raisons de simplicité, on utilise les mêmes signes de référence qu'à la figure Fig. 3). Des substrats silicium ayant une épaisseur de 600-750 µm ont été nettoyés pendant 5 min dans un bain ultrasonique d'acétone et isopropanol. Les substrats ont ensuite été séchés et posés sur une plaque chaude à 400°C pour améliorer l'adhérence entre le silicium et la résine.

La résine photosensible choisie était une résine positive avec seuil, notamment une résine S1813 (société Microchem), sensible aux longueurs d'onde de 405 nm et une résolution de 0,5 µm. La résine, diluée à 50% dans un solvant (Microposit EC) a été déposée en une couche mince de 350 nm au moyen d'un spin coater (30 s à 4 000 trs/min, accélération 3 000 trs/s). Le solvant a été évaporé dans un four à 110°C.

Le substrat 44 ainsi préparé avec sa couche mince de résine photosensible 48 a ensuite été placé dans un système optique du type de la Fig.3 (équipé d'un laser à 450 nm) pour subir une étape d'insolation comportant une triple exposition interférentielle à trois faisceaux coplanaires, conformément à la présente invention. L'image a) montre le principe d'une exposition interférentielle, dans laquelle les trois faisceaux lumineux 58.1, 58.2 et 58.3 produits par le système optique convergent sur une même partie de la surface et interfèrent ensemble. Trois expositions interférentielles de la résine 48 ont été réalisées, pour des positions angulaires du substrat de 0°, 60° et 120°. Chaque exposition a été réalisée dans les mêmes conditions pour les faisceaux incidents (intensité du faisceau central vaut la moitié de celle des faisceaux latéraux), avec une durée de quelques dizaines de secondes, selon l'intensité du faisceau laser insolant l'échantillon.

Cette étape d'insolation permet donc d'induire le motif de la figure d'interférence produite par les trois faisceaux coplanaires, comme représenté par l'image b). Les zones insolées (i.e. dans lesquelles l'intensité lumineuse de la figure d'interférence était supérieure au seuil de sensibilité de la résine) sont désignées 70.

### 2. Développement de la résine - Fig.4 c)

Après l'étape d'insolation, la résine est développée pour révéler la structure induite. Le développement a été réalisé dans une solution de développeur MF319 (MicroChem) pendant 30 s, suivi d'un rinçage à l'eau.

Puisqu'il s'agit d'une résine positive, le développement révèle des trous 72 correspondant aux formes d'étoiles à trois branches désirées, symbolisé par l'image c). Dans le cadre du procédé lift-off, les trous formés dans la résine s'étendent jusqu'à la face supérieure 46 du substrat 44.

### 3. Dépôt d'or - Fig.4 d)

L'image d) représente le dépôt d'or par évaporation. Après développement de la résine, on a d'abord préférentiellement formé une couche d'adhésion en Chrome de 3 nm d'épaisseur (non représentée). Puis une couche d'or de 50 nm, désignée 74, a été déposée par évaporation thermique (à la vitesse de 1 nm/s).

### 4. Lift-off - Fig.4 e)

Conformément au procédé lift-off, la dernière étape vise à enlever le matériau sacrificiel, i.e. la résine, restant sur le substrat 44.

Pour permettre le lift-off, on ajustera, de manière classique, les épaisseurs respectives du matériau sacrificiel (résine) et de la couche de matériau cible (or) déposée sur cette dernière. En effet, si l'épaisseur de résine est trop importante, le matériau cible se dépose sur les flancs des découpes, ce qui protège la résine sous-jacente (image e, gauche).

Afin de garantir le lift-off, l'épaisseur de résine 48, dans le présent exemple, n'excède généralement pas le triple de l'épaisseur de la couche 74 d'or. Le phénomène d'ombrage empêche le dépôt d'or sur les flancs du profil de résine et mène donc à une discontinuité de la couche d'or (notée 74.1) entre le dessus de la résine et la couche d'or (notée 74.2) formée dans les trous, sur le substrat 44. Il est ainsi possible de dissoudre chimiquement la résine 48 et d'enlever par la même le métal 74.1 déposé sur cette dernière. Dans le présent exemple, la résine a été dissoute avec de l'acétone.

Une fois le lift-off réalisé, la face supérieure 46 du substrat 44 porte uniquement les nanostructures métalliques 74.2 désirées, ici les nano-étoiles à trois branches en or. C'est ce qui est schématisé à la Fig.4 f), la figure 2 montrant une image MEB de ces étoiles telles qu'obtenues dans le cadre du présent exemple.

### Système optique employant un prisme tronqué

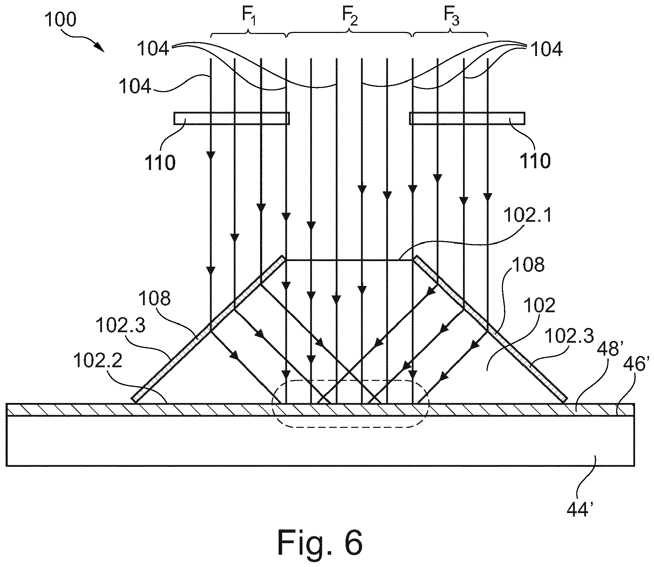

La figure 6 représente un mode de réalisation d'un système optique 100 employant un prisme tronqué, permettant la mise en œuvre du présent procédé.

On reconnaitra en partie inférieur un substrat 44' dont la surface supérieure 46' est couverte d'un film de résine photosensible 48'. Ces éléments ont déjà été décrits en détails dans le cadre du système optique de la figure 3.

Le signe de référence 102 désigne un prisme présentant une face supérieure 102.1 et une face inférieure 102.2 (ou base) planes et parallèles Dans le plan vertical de la figure, le prisme 102 a une section trapézoïdale : la base 102.2 est donc plus large que la face supérieure 102.1 et on a deux faces latérales 102.3 opposées et symétriques qui rejoignent les deux faces 102.1 et 102.2. Un tel prisme peut être typiquement un prisme droit, notamment un prisme de Dove, qu'on a placé sur une face latérale. Le prisme est dans un matériau transparent à la lumière, typiquement en verre flint ou crown pour le visible ou quartz dans l'UV.

Les faisceaux de lumière coplanaires, suffisamment cohérents et épurés, d'une manière connue en soi, pour avoir les qualités minimales d'onde plane nécessaires à l'obtention des interférences, sont généralement indiqués 104 et sont dirigés, en amont du prisme, perpendiculairement à la surface de la résine. La partie centrale des faisceaux attaque la surface supérieure plane 102.1 (parallèle à sa base 102.2 et à la surface supérieure de la résine) du prisme 102, traverse ce dernier et atteint la région de la surface de la résine avec un angle d'incidence de 90°. Cela forme donc le faisceau central F2.

De part et d'autre du faisceau central, les faisceaux coplanaires 104 arrivent sur les faces latérales inclinées du prisme 102.3 subissent une déviation (réfraction) lors de leur pénétration dans le prisme, et arrivent à la région de la surface de la résine avec un angle d'incidence différent de 90°. Les faisceaux latéraux F1 et F3 sont ainsi formés.

Dans ce système, la phase et l'intensité peuvent avantageusement être contrôlés par des couches optiques disposées sur les faces latérales ou à distance.

Par exemple, la phase des faisceaux latéraux est contrôlée au moyen de couches optiques minces 108 formées sur les faces latérales 102.3 opposées du prisme. Il s'agit de couches d'adaptation d'épaisseur qui peuvent avoir une épaisseur de l'ordre d'une fraction de la longueur d'onde et réalisées en matériaux transparents type résine ou semiconducteurs ou encore oxyde.

Pour atténuer l'intensité des faisceaux latéraux, deux lames 110 dites « densité optique » sont positionnées sur le chemin des faisceaux lumineux d'extrémité, en amont du prisme, à la verticale des faces latérales 102.3. Les densités optiques sont généralement des couches absorbantes, qui peuvent avoir une épaisseur de l'ordre de quelques nanomètres dans le cas de métaux ou encore de quelques dizaines de nanomètres voir centaines de nanomètres si réalisées à l'aide d'oxydes dopés.

Alternativement, ces densités optiques pourraient être formées en tant que couches minces directement sur les surfaces latérales du prisme, par ex. au-dessus des couches de contrôle de phase 108.

Le prisme 102 permet d'obtenir trois faisceaux coplanaires qui se rencontrent et interférent dans la région de la base du prisme (indiquée en pointillés), à proximité de la surface de la résine 48'. Il est ainsi possible d'insoler la résine 48' par des figures d'interférences, de manière similaire au système optique de la figure 3.

On remarquera que l'usage du prisme 102 dans le système optique 100 permet une grande compacité. Il assure en même la séparation des faisceaux et leur orientation, dirigeant les faisceaux latéraux pour les faire interférer dans la région de sa base 102.2.

Le prisme 102 peut être posé directement sur la couche de résine photosensible 48'. Il pourrait aussi être légèrement espacé. On notera encore qu'avec un substrat transparent et de faible épaisseur, la base du prisme peut être placée contre la face arrière du substrat (opposée à la face portant la résine), afin d'insoler la résine à travers le substrat. Il s'agit alors d'une insolation interférentielle par transmission.

## Revendications

1. Procédé de fabrication de structures à symétrie limitée par lithographie interférentielle comprenant une étape d'insolation par lithographie interférentielle d'un matériau photosensible (18) disposé sur un substrat (20) ;
**caractérisé en ce que** l'étape d'insolation comprend au moins trois expositions interférentielles successives réalisées avec trois faisceaux lumineux coplanaires (12, 14, 16) issus d'un système optique et interférant sur une surface d'exposition du matériau photosensible ; une première rotation relative étant réalisée entre ledit système optique et ledit substrat entre la première et la deuxième exposition interférentielle, puis une deuxième rotation entre la deuxième et la troisième exposition interférentielle.

2. Procédé selon la revendication 1, dans lequel on contrôle les intensités relatives des faisceaux coplanaires.

3. Procédé selon la revendication 2, dans lequel un faisceau central a une intensité valant la moitié de celle des faisceaux extérieurs.

4. Procédé selon la revendication 1, 2 ou 3, dans lequel on module les phases respectives des faisceaux lumineux ; et préférablement on contrôle les phases respectives des faisceaux.

5. Procédé selon l'une quelconque des revendications précédentes, dans lequel les trois faisceaux lumineux coplanaires sont émis par un système optique qui produit : un faisceau central, de préférence ayant un angle d'incidence normal par rapport au plan du substrat, et deux faisceaux latéraux, de part et d'autre du faisceau central et dans un même plan, les faisceaux latéraux ayant un angle d'incidence inférieur à 90 degrés par rapport au plan du substrat, les trois faisceaux lumineux étant dirigés sensiblement sur la surface d'exposition du matériau photosensible afin de produire une figure d'interférences.

6. Procédé selon la revendication 5, dans lequel l'angle d'incidence (par rapport à la normale à la surface) des faisceaux latéraux est compris entre 5° et 70°.

7. Procédé selon l'une quelconque des revendications précédentes, dans lequel les trois expositions sont réalisées à des angles de 0°, 60° et 120° ; le mouvement de rotation relative du substrat étant préférablement réalisé par déplacement du substrat.

8. Procédé selon l'une quelconque des revendications précédentes, dans lequel le système optique comprend un moyen formeur de faisceau recevant en entrée un faisceau lumineux produit par une source de lumière cohérente, et apte à générer les trois faisceaux lumineux coplanaires.

9. Procédé selon l'une quelconque des revendications précédentes, comprenant en outre :
une étape de développement du matériau photosensible pour libérer sélectivement des régions prédéfinies de la surface d'exposition, suite à l'étape d'insolation ; et
une étape de fabrication de la structure conformément au masque formé par le matériau photosensible développé.

10. Procédé selon la revendication 9, dans lequel l'étape de fabrication comprend le dépôt de matière, en particulier par évaporation de métal, à travers le masque et la dissolution successive du matériau photosensible.

11. Procédé selon l'une quelconque des revendications précédentes, dans lequel la structure fabriquée sur le substrat comprend des nanoparticules ou groupes de nanoparticules présentant une forme ou une disposition ayant un axe de symétrie perpendiculaire à une face de type Cn où n est supérieur ou égal à trois ; et dans lequel les nanoparticules sont métalliques et/ou semi conductrices, et/ou les nanoparticules présentent une dimension comprise entre le nanomètre et quelques dizaines de micromètres, et/ou les nanoparticules sont disposées sur au moins une partie dudit substrat selon un pavage régulier ou quasi-cristallin, en fonction du réseau dans lequel lesdites nanoparticules sont incluses.

12. Système optique pour la fabrication de structures à symétrie limitée par lithographie interférentielle comprenant :
un porte échantillon ;
une source de lumière cohérente émettant un faisceau lumineux source ;
des moyens pour former, à partir du faisceau source, trois faisceaux lumineux coplanaires (F1,F2, F3) dirigés sur une surface d'exposition d'une résine photosensible (48') recouvrant un substrat (44') de sorte à interférer ;
des moyens pour faire pivoter le porte échantillon afin de réaliser plusieurs expositions interférentielles de la résine ;
les moyens pour former le faisceau comprenant un prisme (102) présentant une face inférieure (102.2) et une face supérieure (102.1) planes et parallèles et deux faces latérales (102.3) opposés obliques, la face inférieure du prisme étant positionnée à proximité ou au contact du substrat recouvert de la couche de résine photosensible lors de l'utilisation, alors que le faisceau lumineux source est dirigé perpendiculaire à la face inférieure du prisme, et tombe sur la face supérieure du prisme ainsi que sur deux faces latérales obliques ;
**caractérisé en ce que** le prisme est configuré de sorte que les faisceaux pénétrant par la face supérieure arrivent avec une incidence normale sur la face inférieure du prisme et les faisceaux lumineux pénétrant par les faces latérales convergent vers la face inférieure du prisme pour interférer ;
**en ce qu'**une couche d'adaptation d'épaisseur (108) est optionnellement déposée sur chacune desdites faces latérales obliques du prisme pour contrôler la phase des faisceaux lumineux ; et
**en ce qu'**une densité optique (110) est positionnée soit sur le chemin des faisceaux lumineux (F1, F3) tombant sur les faces latérales obliques, soit sur le chemin des faisceaux lumineux tombant sur la face supérieure du prisme, afin d'atténuer leur intensité, ladite densité optique pouvant prendre la forme d'une lame positionnée à distance du prisme ou bien d'une couche formée sur le prisme, respectivement sur ladite couche d'adaptation d'épaisseur.

## Patentansprüche

1. Verfahren zur Herstellung von Strukturen mit begrenzter Symmetrie durch Interferenzlithographie, das einen Schritt zur Belichtung mithilfe der Interferenzlithographie eines lichtempfindlichen Materials (18) umfasst, das auf einem Substrat (20) angeordnet ist;
**dadurch gekennzeichnet, dass** der Schritt zur Belichtung mindestens drei aufeinanderfolgende Interferenzbelichtungen umfasst, die mit drei koplanaren Lichtstrahlenbündeln (12, 14, 16) ausgeführt werden, die von einem optischen System stammen und auf einer Belichtungsfläche des lichtempfindlichen Materials interferieren; wobei eine erste relative Drehung zwischen dem optischen System und dem Substrat zwischen der ersten und der zweiten Interferenzbelichtung und dann eine zweite Drehung zwischen der zweiten und der dritten Interferenzbelichtung erfolgt.

2. Verfahren nach Anspruch 1, wobei die relativen Intensitäten der koplanaren Strahlenbündel gesteuert werden.

3. Verfahren nach Anspruch 2, wobei ein mittiges Strahlenbündel eine Intensität aufweist, die gleich der Hälfte von der der äußeren Strahlenbündel ist.

4. Verfahren nach Anspruch 1, 2 oder 3, wobei die jeweiligen Phasen der Lichtstrahlenbündel moduliert werden; und vorzugsweise die jeweiligen Phasen der Strahlenbündel gesteuert werden.

5. Verfahren nach einem der vorangehenden Ansprüche, wobei die drei koplanaren Lichtstrahlenbündel von einem optischen System emittiert werden, das Folgendes erzeugt: ein mittiges Strahlenbündel, vorzugsweise mit einem zur Substratebene normalen Einfallswinkel, und zwei seitliche Strahlenbündel an den beiden Seiten des mittigen Strahlenbündels und in der gleichen Ebene, wobei die seitlichen Strahlenbündel einen Einfallswinkel von kleiner als 90 Grad zur Substratebene aufweisen und die drei Lichtstrahlenbündel im Wesentlichen auf die Belichtungsfläche des lichtempfindlichen Materials geleitet werden, um ein Interferenzbild zu erzeugen.

6. Verfahren nach Anspruch 5, wobei der Einfallswinkel der seitlichen Strahlenbündel (in Bezug auf die Flächennormale) im Bereich von 5° und 70° liegt.

7. Verfahren nach einem der vorangehenden Ansprüche, wobei die drei Belichtungen unter den Winkeln von 0°, 60° und 120° erfolgen; und wobei die relative Drehbewegung für das Substrat vorzugsweise durch Ortsänderung des Substrats erfolgt.

8. Verfahren nach einem der vorangehenden Ansprüche, wobei das optische System ein Strahlenbündel-Bildungsmittel umfasst, das am Eingang ein von einer kohärenten Lichtquelle erzeugtes Lichtstrahlenbündel erhält und drei koplanare Lichtstrahlenbündel erzeugen kann.

9. Verfahren nach einem der vorangehenden Ansprüche, das außerdem Folgendes umfasst:
einen Schritt zur Entwicklung des lichtempfindlichen Materials, um selektiv vordefinierte Regionen der Belichtungsfläche freizugeben, im Anschluss an den Schritt der Belichtung; und
einen Schritt zur Herstellung der Struktur gemäß der Maske, die vom entwickelten lichtempfindlichen Material gebildet wurde.

10. Verfahren nach Anspruch 9, bei dem der Schritt zur Herstellung das Aufbringen von Material, insbesondere durch Metallaufdampfung, durch die Maske hindurch und die anschließende Auflösung des lichtempfindlichen Materials umfasst.

11. Verfahren nach einem der vorangehenden Ansprüche, wobei die auf dem Substrat hergestellte Struktur Nanoteilchen oder Gruppen von Nanoteilchen umfasst, die eine Form oder eine Anordnung mit einer Symmetrieachse senkrecht zu einer Fläche vom Typ Cn aufweisen, wobei n größer als oder gleich drei ist; und wobei die Nanoteilchen metallisch und/oder halbleitend sind und/oder die Nanoteilchen eine Abmessung aufweisen, die im Bereich eines Nanometers oder mehrerer zehn Mikrometer liegt und/oder die Nanoteilchen mindestens auf einem Teil des Substrats gemäß einem regelmäßigen oder quasikristallinen Muster angeordnet sind, und zwar in Abhängigkeit des Netzes, in dem Nanoteilchen eingeschlossen sind.

12. Optisches System für die Herstellung von Strukturen mit begrenzter Symmetrie durch Interferenzlithographie, umfassend:
einen Probenhalter;
eine kohärente Lichtquelle, die ein Ausgangslichtstrahlenbündel emittiert;
Mittel für das Bilden aus dem Ausgangslichtstrahlenbündel von drei koplanaren Lichtstrahlenbündeln (F1, F2, F3), die auf eine Belichtungsfläche eines lichtempfindlichen Harzes (48'), das ein Substrat (44') bedeckt, geleitet werden, um zu interferieren;
Mittel zum Drehen des Probenhalters, um für das Harz mehrere Interferenzbelichtungen auszuführen;
wobei die Mittel zum Bilden des Strahlenbündels Folgendes umfassen:
ein Prisma (102), das eine untere Fläche (102.2) und eine obere Fläche (102.1), die eben und parallel sind, und zwei seitliche Flächen (102.3) aufweist, die entgegengesetzt schräg sind, wobei bei der Anwendung die untere Fläche des Primas in der Nähe des Substrats oder in Kontakt mit dem Substrat, das mit der lichtempfindlichen Harzschicht bedeckt ist, angeordnet wird, während das Ausgangslichtstrahlenbündel senkrecht zur unteren Fläche des Prismas geleitet wird und auf die obere Fläche des Prismas sowie auf die zwei schrägen seitlichen Flächen fällt;
**dadurch gekennzeichnet, dass** das Prisma so konfiguriert ist, dass die durch die obere Fläche eindringenden Strahlenbündel unter einem normalen Einfall auf die untere Fläche des Prismas gelangen und die durch die seitlichen Flächen eindringenden Lichtstrahlenbündel zum Interferieren zur unteren Fläche hin konvergieren;
dass eine Dickenanpassungsschicht (108) optional auf jeder der schrägen seitlichen Flächen des Prismas angeordnet ist, um die Phase der Lichtstrahlenbündel zu steuern; und
dass eine optische Dichte (110) entweder angeordnet ist auf dem Weg der Lichtstrahlenbündel (F1, F3), die auf die schrägen seitlichen Flächen fallen, oder auf dem Weg der Lichtstrahlenbündel, die auf die obere Fläche des Prismas fallen, um deren Intensität abzuschwächen, wobei die optische Dichte die Form eines vom Prisma entfernt angeordneten Plättchens oder einer auf dem Prisma gebildeten Schicht, beziehungsweise auf der Dickenanpassungsschicht, annehmen kann.

## Claims

1. A method for manufacturing limited-symmetry structures by interference lithography comprising a step of interference lithographic irradiation of a photosensitive material (18) arranged on a substrate (20), **characterised in that** the irradiation step comprises at least three successive interference exposures carried out with three coplanar light beams (12, 14, 16) originating from an optical system and interfering on an exposure surface of the photosensitive material, a first relative rotation being carried out between said optical system and said substrate between the first and second interference exposures, followed by a second rotation between the second and third interference exposures.

2. The method according to claim 1, in which the relative intensities of the coplanar beams are controlled.

3. The method according to claim 2, in which a central beam has an intensity half that of the outer beams.

4. The method according to claim 1, 2 or 3, in which the respective phases of the light beams are modulated, the respective phases of the beams preferably being controlled.

5. The method according to any one of preceding claims, in which the three coplanar light beams are emitted by an optical system which produces a central beam, preferably having an angle of incidence normal to the plane of the substrate, and two side beams on either side of the central beam and in the same plane, the side beams having an angle of incidence of less than 90 degrees relative to the plane of the substrate and the three light beams being directed substantially onto the exposure surface of the photosensitive material in order to produce an interference pattern.

6. The method according to claim 5, in which the angle of incidence (relative to the normal to the surface) of the side beams is between 5° and 70°.

7. The method according to any one of preceding claims, in which the three exposures are made at angles of 0°, 60° and 120°, the relative rotational movement of the substrate preferably being carried out by displacing the substrate.

8. The method according to any one of preceding claims, in which the optical system comprises a beam-forming means which receives as input a light beam produced by a coherent light source and is capable of generating the three coplanar light beams.

9. The method according to any one of preceding claims, further comprising:
a step of developing the photosensitive material to selectively uncover predefined regions of the exposure surface, following the irradiation step, and
a step of manufacturing the structure in accordance with the mask formed by the developed photosensitive material.

10. The method according to claim 9, in which the manufacturing step comprises depositing material, in particular by evaporating metal, through the mask and subsequently dissolving the photosensitive material.

11. The method according to any one of preceding claims, in which the structure manufactured on the substrate comprises nanoparticles or groups of nanoparticles which have a shape or arrangement with an axis of symmetry perpendicular to a face of the type Cn in which n is greater than or equal to three, and in which the nanoparticles are metallic and/or semi-conductive, and/or the nanoparticles have a size of between one nanometre and a few tens of micrometres, and/or the nanoparticles are arranged on at least part of said substrate in accordance with regular or quasi-crystalline pattern, depending on the network in which said nanoparticles are included.

12. The optical system for manufacturing limited-symmetry structures by interference lithography comprising:
a sample holder,
a coherent light source emitting a source light beam,
means for forming, from the source beam, three coplanar light beams (F1, F2, F3) directed onto an exposure surface of a photosensitive resin (48') covering a substrate (44') so as to interfere,
means for causing the sample holder to pivot in order to make multiple interference exposures of the resin,
the beam-forming means comprising a prism (102) having a lower face (102.2) and an upper face (102.1) which are planar and parallel and two opposing oblique side faces (102.3), the lower face of the prism being positioned in the vicinity of or in contact with the substrate covered with the layer of photosensitive resin when in use, while the source light beam is directed perpendicular to the lower face of the prism, and impinges on the upper face of the prism as well on two oblique side faces,
**characterised**
**in that** the prism is configured such that the beams entering via the upper face arrive with a normal incidence at the lower face of the prism and the light beams entering via the side faces converge towards the lower face of the prism in order to interfere,
**in that** a thickness-adjustment layer (108) is optionally deposited on each of said oblique side faces of the prism in order to control the phase of the light beams, and
**in that** an optical density (110) is positioned either in the path of the light beams (F1, F3) impinging on the oblique side faces or in the path of the light beams impinging on the upper face of the prism, in order to attenuate the intensity thereof, said optical density possibly taking the form of a slide positioned at a distance from the prism or alternatively of a layer formed on the prism or on said thickness-adjustment layer.
